(19) Europäisches Patentamt

European Patent Office

Office européen des brevets

(11) **EP 1 260 359 B1**

(12) **EUROPEAN PATENT SPECIFICATION**

(45) Date of publication and mention of the grant of the patent:
**07.12.2005 Bulletin 2005/49**

(51) Int Cl.⁷: **B32B 31/08**, B32B 31/20

(21) Application number: **02011363.5**

(22) Date of filing: **23.05.2002**

(54) **Method for manufacturing a laminated board**

Verfahren zur Herstellung einer mehrschichtigen Platte

Procédé de fabrication d'une plaque stratifiée

(84) Designated Contracting States:
**DE FR GB**

(30) Priority: **24.05.2001 JP 2001155595**

(43) Date of publication of application:
**27.11.2002 Bulletin 2002/48**

(60) Divisional application:
**05007899.7 / 1 555 121**

(73) Proprietor: **SUMITOMO BAKELITE CO., LTD.**
**Tokyo 140-0002 (JP)**

(72) Inventor: **Ilda, Takahisa,**
**Sumitomo Bakelite Co. Ltd.**
**Shinagawa-ku, Tokyo 140-0002 (JP)**

(74) Representative: **Solf, Alexander**
**Patentanwälte**
**Dr. Solf & Zapf**
**Candidplatz 15**
**81543 München (DE)**

(56) References cited:
**EP-A- 0 130 312**      **GB-A- 2 057 351**
**US-A- 4 087 300**      **US-A- 4 557 784**
**US-A- 4 659 425**      **US-A- 5 919 525**

**Description**

## BACKGROUND OF THE INVENTION

### Field of the Invention

The present invention relates to a method for manufacturing a laminated board (laminated sheet) of the kind defined by the precharacterizing clause of claim 1 and known from the EP-0 130 312, and more particularly to a method for continuously manufacturing a laminated board suitable for printed circuit boards used in electrical apparatuses, electronic apparatuses and communication equipment.

### Description of the Prior Art

In recent years, reduction in size and higher functions are further required for printed circuit boards while price competition is becoming more severe. For this reason, it is important for manufactures of the laminated boards to reduce the price thereof.

Digitization has also been advanced in electronic apparatuses and the like. Printed circuit boards used in such electronic apparatuses are required to have a stable impedance. For providing such printed circuit boards having a stable impedance, a laminated board which is a base material for the printed circuit boards is required to have high sheet thickness precision (thickness accuracy).

Normally, the laminated board used for printed circuit boards is formed by a multi-step batch press method using a multi-platen press. In the multi-step batch press method, several sets of materials for laminated boards, each set being comprised of a copper foil, a prepreg, an internal printed circuit layer, a pair of mirror surfaced plates or the like are prepared, and each set is placed between platens in the multi-platen press, so that they are molded by heating and pressing simultaneously.

However, since the productivity of the multi-step batch press method is low, it is difficult to reduce the price of the laminated boards by using this method. In the multi-step batch press method, each laminated board is molded under a high pressure of 20 to 100kg/cm$^2$, so that it is difficult to obtain sufficient sheet thickness precision due to overflow of the resin.

In the multi-step batch press method, the history of heat applied to each laminated board during molding varies from one laminated board to another due to the presence of nonuniformity in the temperature of the platens among respective steps. Because of this, differences are likely to be generated in the qualities such as moldability, warpage, rate of change in size or the like, so that it is difficult to supply laminated boards with small variations in the quality.

## SUMMARY OF THE INVENTION

It is therefore the object of the present invention to provide a method for manufacturing a high quality laminated board with high productivity.

This object is achieved by the features of claim 1.

Further, it is also preferred that the prepreg includes a first layer having a sheet-form base to which a thermosetting resin is impregnated, and a second layer which is formed onto the both surfaces of the first layer by applying a thermosetting resin thereto.

Further, it is preferred that the rate of reaction (hereinafter, referred to as "reactivity") of the thermosetting resin used in the first layer is higher than that of the second layer.

In the present invention, it is also preferred that the metal foil is continuously bonded to the prepreg while the prepreg is being fed substantially vertically.

Further, it is also preferred that the bonding of the metal foil to the prepreg is carried out by passing them through between at least a pair of rolls. In this case, it is preferred that each of the rolls has a surface formed from an elastic material.

Furthermore, in the present invention, it is preferred that the metal foil has a sticky resin layer.

Moreover, in the present invention, it is preferred that the method further comprises the step of heating the prepreg prior to the step of the bonding of the metal foil to the prepreg. It is also preferred that the method further comprises the step of rolling the laminated board continuously after the step of the bonding of the metal foil to the prepreg.

These and other objects, structures and advantages of the present invention will be apparent when the following descriptions of the preferred embodiments will be considered.

## BRIEF DESCRIPTION OF THE DRAWINGS

Fig. 1 is a schematic diagram which generally shows the manufacturing method of a laminated board according to the present invention.

Fig. 2 is a cross-sectional view which schematically shows one example of a prepreg manufactured according to the present invention.

Fig. 3 is a side view which schematically shows one example of a roll used in the manufacturing method according to the present invention.

## DETAILED DESCRIPTION OF THE PREFERRED EMBODIMENTS

In the following, a manufacturing method of a laminated baord according to the present invention will be described in detail with reference to the preferred embodiments shown in the accompanying drawings.

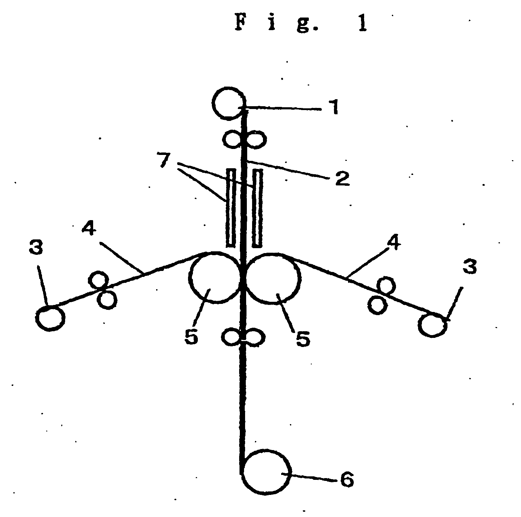

Fig. 1 is a schematic diagram which generally shows the manufacturing method of the laminated board according to the present invention. As shown in Fig. 1, a prepreg 2 supplied from a prepreg supply section 1 is fed vertically using feed rolls. At the same time, metal foils 4, 4 are respectively supplied from metal foil supply sections 3 using feed rolls. These metal foils 4, 4 are respectively bonded to the prepreg 2 which has been heated by a heating section 7 when they pass through between rolls 5, thereby forming a laminated board. Thus formed laminated board is fed to a rolling section 6 using feed rolls. By rolling up the laminated board continuously around the rolling section 6, it is possible to manufacture the laminated board continuously.

The prepreg used for this invention includes multiple layers of thermosetting resin. With this arrangement, it is possible to provide various prepregs in which their respective layers can exhibit different functions.

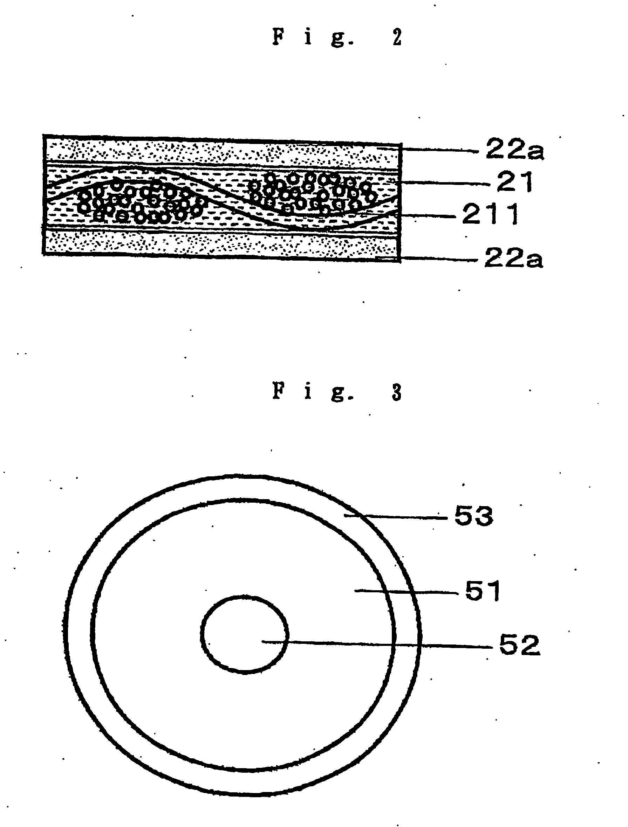

As shown in Fig. 2, the laminated board of this embodiment is composed of a prepreg 2 which includes three layers of thermosetting resin. Namely, the prepreg 2 includes a first layer 21 formed by impregnating a thermosetting resin into a sheet-form base material 211, and a second layer 22a (22a, 22a) formed by coating the thermosetting resin on both faces of the first layer 21. In this manner, it is possible to impart different functions to the first and second layers 21, 22a. In this regard, it is to be noted that the boundary between the first and second layers can be given a continuous structure where the both layers are merged with each other.

Examples of the sheet-form base material include a glass fiber base material such as a glass woven fabric, a glass nonwoven fabric and glass paper; a woven or nonwoven fabric formed of paper, synthetic fiber or the like; and a woven or nonwoven fabric, a mat or the like formed of metallic fiber, carbon fiber, mineral fiber or the like. These materials may be used alone or by combining two ore more of them. Among these materials, the glass fiber base material is particularly preferred. By using such a material, it is possible to enhance the stiffness and size stability of the laminated board.

Examples of the thermosetting resin include an epoxy resin, a phenolic resin, a melamine resin, and their modified resins, and the like. Among these resins, the epoxy resin is preferred, and a bisphenol A epoxy resin is especially preferred. With this choice, the electrical insulation property and the adhesion property can be improved. Moreover, it is preferred to use a bisphenole A epoxy resin and a novolak epoxy resin in the weight ratio of 95:5 to 60: 40, and it is especially preferred to use them in the ratio of 80:20 to 70:30. With this choice, the heat resistance is also improved in addition to the above two effects. In this connection, it is to be noted that in this invention, an amine-based curing agent such as dicyandiamide or the like, or an imidazole-based curing agent such as 2-phenyl-4-methyl-5-methoxy imidazole or the like may be used as the curing agent for the thermosetting resin.

Although different kinds of thermosetting resin may be used for each layer as the thermosetting resin constituting the layer, it is preferred to use the same kind of thermosetting resin for both layers. This makes it possible to improve the adhesion between the layers of the prepreg.

Additives such as a filler and a coloring agent may be added to the thermosetting resin. Although the kind of the filler to be added is not particularly limited, it is preferred to use an inorganic filler. With this choice, it is possible to impart the thermosetting resin with the tracking resistance, heat resistance, low thermal expansion or the like. Examples of the inorganic filler include hydroxides such as aluminum hydroxide and magnesium hydroxide, calcium carbonate, talc, wallastonite, alumina, silica, unfired clay, fired clay, barium phosphate and the like. Among these substances, aluminum hydroxide is particularly preferred. With this choice, it is possible to further improve the tracking resistance of the laminated board. In this connection, it is preferred to compound 50 to 300 parts by weight of the inorganic filler with respect to 100 parts by weight of the thermosetting resin. If the amount of the added inorganic filler is below 50 parts by weight, there is a case that the improved effect for the tracking resistance is lowered. On the other hand, if it exceeds 300 parts by weight, there is a case that the solderability becomes poor. Further, examples of the coloring agent include a fluorescent dye or the like.

The method for impregnating the thermosetting resin into the sheet-form fiber base material is not particularly limited as long as it can satisfactorily impregnate the resin, so that any method such as immersion of the base material into a resin varnish, coating of a resin to the base material using various kinds of coaters, or spraying of a resin using a spray may be adopted.

Further, although the thermosetting resins for the first layer and the second layer may be of the same kind, it is preferable to employ those with different conditions.

Further, the reactivity of the thermosetting resin of the first layer is not particularly limited, but it is preferred that the reactivity is higher than that of the thermosetting resin of the second layer. The first layer formed of the thermosetting resin having such reactivity functions to improve the sheet thickness precision of the laminated board, and the second layer formed of the thermosetting resin having such reactivity functions to improve the adhesion with the metal foil.

The reactivity of the thermosetting resin in the first layer is not particularly limited, but it is preferred that the reactivity is equal to or higher than 85%. This makes it possible to further improve the sheet thickness precision of the laminated board. In addition, the reactivity of the thermosetting resin in the second layer is not particularly limited, but it is preferred that the reactivity is equal to or lower than 65%. This makes it possible to further improve the adhesion with the metal foil. Furthermore, it is preferred that the reactivity of thermosetting resin in the first layer is equal to or higher than 85% and the reactivity of the thermosetting resin in the second layer is equal to or lower than 65%. In this way, in addition to the two effects in the above, generation of resin dust by the bending or the like of the prepreg can readily be suppressed.

In the present invention, it is more preferable that the reactivity of the thermosetting resin in the first layer is 90 to 95%, and that the reactivity of the thermosetting resin in the second layer is equal to or lower than 20% (especially in the range of 0.1 to 20%). Further, it is most preferable that the reactivity of the thermosetting resin in the first layer is 90 to 95%, and that the reactivity of the thermosetting resin in the second layer is equal to or lower than 20%. This makes it possible, in addition to the improvement in the adhesion and the sheet thickness precision of the laminated board and the prevention of the generation of resin dust described above, to prevent an overflow of the resin and improve the moldability.

The reactivity can be determined by differential scanning calorimetry (DSC). Namely, it can be determined by the following formula (I) through comparison of the areas of the exothermic peaks of reactions by DSC obtained for both of the unreacted resin and the resin of each layer. The measurement may be done in a nitrogen atmosphere with the rate of temperature rise of 10°C/min.

$$\text{Reactivity(\%)} = (1 - \text{area of reaction peak of resin} \,/$$

$$\text{area of reaction peak of unreacted resin}) \times 100 \qquad\qquad (I)$$

The reactivity of the prepreg can be controlled by various methods such as control of the heating temperature and/or heating time or adoption of irradiation with light or electron beam or the like. However, the control by means of the heating temperature and/or heating time is preferable in the sense that it is easy but has high precision.

The amount of impregnation and the amount of coating of the thermosetting resin differs depending upon the material, nature and weight (per unit area) of the sheet-form fiber base material. Accordingly, the weight ratio of the resin for the second layer with respect to the resin of the first layer is not particularly limited, but it is preferred to be in the range of 0.05 to 2.5, and is especially preferred to be in the range of 0.1 to 2.0. With this choice, the sheet thickness precision and the filling property of the resin into the ruggedness are improved. If the weight ratio exceeds the upper limit, there is a case that the improved effect for the sheet thickness precision after the molding will be lowered. On the other hand, if it is below the lower limit, there is a case that the effect to prevent the generation of remaining voids after the molding as well as the effect to prevent the measling and the blisters in the moisture absorption test of the solder are lowered.

The metal constituting the metal foil to be used in this invention is not particularly limited, but copper or a copper alloy, or aluminum or an aluminum alloy, or the like may be used. Further, it is preferred that the thickness of the metal foil is in the range of 9 to 70 μm, and it is especially preferred that it is in the range of 12 to 35 μm. In this embodiment, such a metal foil 4 is bonded continuously to both sides of the prepreg 2 as described above.

Although the metal foil is not particularly limited, it is preferred that it has a sticky resin layer on its surface. This makes it possible to improve the adhesion between the metal foil and the prepreg. Moreover, the metal foil having such a sticky resin layer can suppress more effectively the formation of resin banks at lamination of the preprg and the metal foil as compared with a normal metal foil with an adhesive, thereby enabling to prevent the generation of voids and wrinkles generated in the laminated board.

When the metal foil has a sticky resin layer, it becomes possible to use a prepreg that has a single thermosetting resin layer. This is because a metal foil with such a sticky resin layer can suppress the generation of resin banks at lamination of the prepreg and the metal foil, thereby enabling to prevent voids and wrinkles that are generated in the laminated board. Accordingly, problems due to banks or the like that occur in the normal metal foil can be eliminated.

The resin that constitutes the stick resin layer is not particularly limited, but an epoxy resin or a phenoxy resin, for example, can be mentioned.

As the resin for constituting the sticky resin layer, it is preferable to use a thermoplastic resin having a weight average molecular weight of more than 10,000. If the weight average molecular weight is less than 10,000, there is a case that the continuous molding of the laminated board is affected during the bonding of the prepreg and the metal foil because of the generation of the resin banks.

It is preferred that the resin for constituting the sticky resin layer contains two or more kinds of epoxy resins, and it is especially preferred that it contains epoxy resins with different molecular weights. Furthermore, a resin which contains a bisphenolic epoxy resin with weight average molecular weight of 10,000 or more, a bisphenolic epoxy resin with epoxy equivalent of 500 or less and a curing agent is most preferable. By using this type of resin, it is possible to keep the interlayer thickness by suppressing the fluidity to a low level during lamination through the use of the heating rolls, as well as to impart high adhesion to the composition. A resin comprised of a single component of a bisphenolic epoxy resin with weight average molecular weight of more than 10,000 may give rise to a case where the flexibility is too high due to a low cross-linking density after curing, and to a case in which workability in coating is affected due to a high viscosity when used as varnish of a predetermined concentration. With a single component of a bisphenolic epoxy resin of epoxy equivalent of less than 500, there is a case that a holdup (a bank of the resin) arises and continuous molding will be affected during the bonding of the metal foil and the prepreg. Examples of the curing agent described above include an imidazole-based curing agent or the like.

Moreover, it is preferred that the resin for constituting the stick resin layer is formed by compounding a bisphenolic epoxy resin with weight average molecular weight of more than 10,000 and a bisphenolic epoxy resin with epoxy equivalent of less than 500 in the ratio of (50 to 70) to (50 to 30)wt%. If the bisphenolic epoxy resin with the weight average molecular weight of more than 10,000 is less than 50wt%, there is a case that the continuous molding will be affected due to an occurrence of resin banks during the bonding of the prepreg and the metal foil. On the other hand, if it exceeds 70wt%, there is a case that the adhesion between the prepreg and the metal foil will be lowered.

The weight average molecular weight can be measured by, for example, gel permeation chromatography (GPC), and the epoxy equivalent can be measured by, for example, perchloric acid titration.

The thickness of the sticky resin layer to be applied to the metal foil is not particularly limited, but it is preferred when it is in the range of 5 to 30 μm, and is especially preferred when it is in the range of 10 to 20 μm.

The feature of this invention resides in that the prepreg and the metal foil are continuously bonded. In this connection, the direction of the feeding of the prepreg is not particularly limited. For example, a method for feeding the prepreg in a horizontal direction, or a method for feeding the prepreg in the vertical direction may be used. Among these methods, it is preferred to use a method in which the prepreg 2 is fed in the vertical direction as shown in Fig. 1. With this method, it is possible to reduce variations in the quality of both faces of the prepreg caused by the presence of uneven pressure or the like.

In this embodiment, the prpreg 2 is heated by the heating section 6 prior to the bonding of the prepreg 2 and the metal foils 4, 4. In this way, it is possible to manufacture the laminated board stably and continuously over a long period of time.

The heating temperature is not particularly limited, but it is preferred that the temperature is in the range of 150 to 250°C, and it is especially preferred that the temperature is in the range of 170 to 240°C. With this choice, adhesion between the prepreg and the metal foil during lamination can be enhanced, and voids in the prepreg can be further decreased. If the heating temperature is less than the lower limit, there is a case that the adhesion will be deteriorated. On the other hand, if it exceeds the upper limit, there is a case that the prepreg undergoes thermal decomposition. The feeding velocity of the prepreg is not particularly limited, but it is preferred that the feeding velocity is in the range of 0.5 to 20m/min, and is especially preferred that the feeding velocity is in the range of 1 to 10m/min. With this choice, it is possible to manufacture the laminated board uniformly without lowering the productivity.

As described above, in this embodiment, bonding of the prepreg 2 and the metal foil 4 is accomplished by passing them through at least one pair of rolls 5.

Each of the rolls 5 has a surface layer 53 composed of an elastic material on the peripheral surface of the roll base material 51 thereof as shown in Fig. 3. With this arrangement, it is possible to further improve the uniformity of bonding between the prepreg and the metal foil. The elastic material is not particularly limited, but various kinds of rubbers such as silicone rubber, isoprene rubber, and ethylene-propylene rubber, and various kinds of thermoplastic elastomer such as a polyamide thermoplastic elastomer, a polyester thermoplastic elastomer, and a polyolefine thermoplastic elastomer may be used. Among these rubbers, silicone rubber is preferred.

In bonding the prepreg and the metal foil by the use of the rolls, the bearing pressure between the rolls (the pressure applied between the rolls) is not particularly limited, but it is preferred to be in the range of 5 to 30 kg/cm$^2$,

and is especially preferred to be in the range of 10 to 15 kg/cm$^2$.

The temperature of the rolls is not particularly limited, but it is preferred to be in the range of 100 to 200°C, and is especially preferred to be in the range of 120 to 180°C.

As described above, when a prepreg having a single thermosetting resin layer is used, it is preferable to use a metal foil having a sticky resin layer along with rolls whose surfaces are composed of an elastic material. With this combination, it is possible to make the bonding between the prepreg and the metal foil stable and uniform even in the case where a prepreg having a single thermosetting resin layer is used. Further, even in this case, it is preferred that the reactivity of the thermosetting resin in the single thermosetting resin layer is equal to or higher than 85%. Under these circumstances, it is possible to manufacture the laminated board continuously in a more stable manner.

The Shore hardness of the rubber on the surface layer of the rolls is not particularly limited, but it is preferred to be equal to or higher than 50, and is especially preferred to be in the range of 70 to 90. If the Shore hardness of the rubber is less than the lower limit, there is a case that the durability of the elastic material will deteriorate.

Further, it is preferred that the thickness of the surface layer is equal to or larger than 0.5mm, and it is particularly preferred to be in the range of 0.5 to 3.5mm. If the thickness of the surface layer is less than the lower limit, there is a case that uniform bonding between the prepreg and the metal foil becomes difficult, and as a result, there is a case that the appearance of the laminated board will deteriorate.

As described above, in the method of manufacturing the laminated board according to this invention, the direction for the feeding of the prepreg is not limited to the vertical direction, and may be in a horizontal direction or in a inclined direction by a prescribed angle from the horizontal. The feeding direction of the metal foil 4 is in the similar situation as to the case of the prepreg 2. Moreover, the heating section 7 for the prepreg 2 may be eliminated, that is, the prepreg may be fed without being heated. Furthermore, the bonding of the prepreg 2 and the metal foil 4 may be accomplished by using a method other than the above described method in which they are passed through between the pair of rolls 5.

Further, it is to be noted that, although in the above embodiment the metal foils are provided on the both surfaces of the prepreg, it is sufficient in this invention that the metal foil is provided on at least one surface of the prepreg.

## Examples

In the following the present invention will be described with reference to the actual examples and a comparative example, but this invention is not limited only to these examples.

### Example 1

<Formation of the Prepreg>

(1) Preparation of varnish

70 parts by weight of bisphenol A epoxy resin with epoxy equivalent of about 450, and 30 parts by weight of phenolic novolak epoxy resin with epoxy equivalent of about 190 were dissolved in 100 parts by weight of methyl ethyl ketone. A solution formed by dissolving 3 parts by weight of dicyandiamide and 0.15 parts by weight of 2-phenyl-4-methyl imidazole in 20 parts by weight of dimethylformamide was added to the above solution, and they were mixed by stirring. In this way, an epoxy resin varnish for glass cloth coating was prepared.

(2) The impregnation and coating of the thermosetting resin to sheet-form fiber base material

The varnish prepared as in the above was impregnated into 0.1mm-thick glass cloth (WEA 116E made by Nittobo Co. Ltd.) being a sheet-form base material so as to have 65 parts by weight of the resin solidified component with respect to 100 parts by weight of the glass cloth. It was then dried at 170°C for 3 minutes in a drying furnace, thereby obtaining a first layer formed from thermosetting resin impregnating glass cloth described above.

Next, each side of the first layer was coated with the thermosetting epoxy resin varnish so that the amount of the solidified component of the thermosetting epoxy resin varnish becomes 45 part by weight with respect to 100 parts by weight of the glass cloth. It was then dried at 170°C for 1.5 minutes in the drying furnace, thereby forming a second layer. In this way, a prepreg composed of the first layer and the second layer formed on the both sides of the first layer was obtained.

(3) Confirmation of the reactivity

For the first layer, the base material obtained by impregnating the epoxy resin varnish into the glass cloth, and then dried at 170°C for 3 minutes in the drying furnace was used as the sample.

The sample for the second layer was obtained by shaving the surface of the prepreg having the first and second layers formed as described in the above.

For each sample of the layer, the exothermic peak was measured using a DSC system (made by TA Instrument Co.). The reactivity was calculated according to the formula (I) in the above by comparing the peak areas of heat generation due to hardening reaction in the vicinity of 160°C for the resin before reaction and for each layer of the resin. As a result, the reactivity was found to be 92% for the first layer and 40% for the second layer.

<Formation of the Metal Foil>

100 parts by weight of brominated phenoxy resin (bromination rate 25% and average molecular weight 30,000), 40 part by weight of bisphenol F epoxy resin (Epicron 830 made by DAINIPPON INC AND CHEMICALS, INCORPORATED), and 3 parts by weight of 2-phenyl-4-methyl-5-methoxy imidazole were added to a mixed solvent containing xylene, propyleneglycolmonomethyl ether and methyl ethyl ketone, and then they were stirred till dissolved, thereby obtaining varnish for a sticky resin. Metal foil having a sticky resin layer was obtained by coating thus formed varnish on a copper foil (FGP made by NIPPON DENKAI Ltd.) with a thickness of 18 μm. The thickness of the sticky resin layer was set at 15 μm.

<Formation of the Laminated board>

The prepreg mentioned above was mounted to the prepreg supply section, the prepreg was fed almost vertically from above to below as shown in Fig. 1, and was heated from its both sides to 160°C using an infrared heater. Each of the copper foils was fed roughly perpendicular to the feeding direction of the prepreg. The prepreg and the copper foils were molded under heat and pressure by letting them pass through a pair of rolls heated to 140°C (note that: the bearing pressure between rolls was 10kg/cm$^2$). Then, the uncured portions were almost cured by an after-curing temperature of 180°C for 60 minutes, to eventually obtain a both-side copper clad laminated board having the thickness of 0.1mm.

The surface layer of each roll was formed using a silicone rubber (Silic-Super H80 made by Meiwa Rubber Industry Co.) with the thickness 2mm, and Shore hardness of 80.

### Example 2

This example was formed in a manner similar to the example 1 except that the reactivity of the first layer of the prepreg was set at 80%.

### Example 3

This example was formed in a manner similar to the example 1 except that the reactivity of the second layer of the prepreg was set at 70%.

### Example 4

This example was formed in a manner similar to the example 1 except that silicone rubber with Shore hardness of 60 was used for the elastic material for the surface layer of the roll.

### Example 5

Conditions in this example were similar to those of the example 1 except that the bearing pressure between the pair of rolls was set at 5kg/cm$^2$.

### Example 6

Conditions in this example were similar to those of the example 1 except that the feeding direction of the prepreg was a horizontal direction, and each of the feeding directions of the copper foils was substantially perpendicular to the feeding direction of the prepreg.

*Example 7*

Conditions in this example were similar to those of the example 1 except that the prepreg was not heated prior to the bonding with the copper foils.

*Example 8*

Conditions in this example were similar to those of the example 1 except that the phenolic resin varnish described below was used as the thermosetting resin.

(1) Preparation of the Varnish

An oil-modified phenolic resin varnish was obtained by bringing 1,600g of phenol and 1,000g of tung oil into reaction at 95°C for 2 hours under the presence of para-toluenesulfonic acid. Then, after adding 650g of para-formaldehyde, 30g of hexamethylenetetramine and 2,000g of toluene and heating to 90°C for 2 hours to bring them into the reaction, the product was concentrated under reduced pressure, then diluted with a mixed solution of toluene and methanol, thereby obtaining the resin component to 50%.

(2) Confirmation of the reactivity

The result for the confirmation of the reactivity revealed that the reactivity of the first and of each second layer was 92 and 40%, respectively.

*Example 9*

Conditions in this example were similar to those of the example 1 except that impregnation and coating of the thermosetting resin to the sheet-form fiber base material were carried out as follows.
The varnish prepared as in the above was impregnated into 0.05mm-thick glass cloth (WEA 116E made by Nittobo Co. Ltd.), being a sheet-form base material, so as to have 40 parts by weight of the resin solidified component with respect to 100 parts by weight of the glass cloth. It was then dried at 170°C for 3 minutes in a drying furnace, thereby obtaining a glass cloth impregnated an epoxy resin. As the result, the reactivity of resin was 90%.

*Comparative Example 1*

One set was formed by overlapping a copper foil of thickness 18 $\mu$m on both sides of the prepreg obtained in the example 1, and 200 sets of it were prepared according to the multi-step batch press method. These sets were molded under heat and pressure by heating them at 170°C for 60 minutes at a pressure of 40kgf/cm$^2$. After molding by heating, a both-side copper-clad laminated board with an insulating layer of thickness of 0.1mm was obtained from each of the respective steps of the press machine.
Results of the evaluation, carried out as described below, obtained from each example and the comparative example are shown in the attached Table 1. For the sheet thickness precision and the moldability, a measurement was taken by using samples having only insulating layers obtained by removing the copper foils through etching from a both-side copper-clad laminated board of size 500mm $\times$ 500mm.

<Evaluation of the Laminated board>

1. Sheet thickness precision

For the sheet thickness precision, the average value and the range of the thickness were measured at 36 measuring points set at lattice points.

2. Moldability

Moldability (whether there were voids and other abnormalities found) was confirmed by visual observation and by an optical microscope.

3. Appearance

Whether wrinkles, scratches, pits and the like were present or not in the substrate of size 500mm x 500mm was confirmed by visual observation.

4. Peel strength of the copper foil

The peel strength of 18 μm copper foil was measured according to JIS C 6481.

5. Solder heat resistance

For solder heat resistance, after etching only one side, and cutting the substrate into pieces of 50mm x 50mm, a moisture absorption treatment of 1 hour under pressure cooker conditions of 121°C and 2.0atm, and boiling for 2 hours, was carried out. Then, after immersion for 30 seconds in a solder bath at 260°C, evaluation of blisters and measling was confirmed by visual observation and by an optical microscope.

6. Productivity

By setting the production quantity per hour of the comparative example (laminated board obtained by the batch press) as 1.0, the production quantities for the laminated boards of the examples 1 to 9 were compared.

In Table 1, with regard to the moldability, rank A means the absence of voids, rank B means that there were voids smaller than 10 μm but was practically usable and rank C means the presence of voids larger than 10 μm and was not practically usable.

Moreover, with regard to the appearance, rank A means the absence of wrinkles and the like, rank B means that there were wrinkles and the like smaller than 100 μm but was practically usable and rank C means that there were wrinkles of larger than 100 μm and was not practically usable.

Furthermore, with regard to the solder heat resistance, rank A means the absence of blisters and the like.

As shown in Table 1, the examples 1 to 9 are superior to the comparative example in the sheet thickness precision, moldability, adhesion (peel strength of the copper foil), and heat resistance, and was superior also in the productivity. From these facts, it became clear that the method of manufacturing the laminated board according to the present invention can provide a high quality laminated board with high productivity. In particular, the examples 1 to 3 have a high productivity of the laminated boards. Moreover, especially the examples 1 and 2 have an excellent adhesion between the prepreg and the copper foil in addition to the high productivity described above. Furthermore, it is also found that especially the example 1 has an excellent sheet thickness precision in addition to the productivity and the adhesion.

## TABLE 1

| Test Items | Sheet Thickness Precision | | Moldability | Appearance | Peel Strength of Copper Foil | Solder heat resistance | | Productivity |
|---|---|---|---|---|---|---|---|---|
| | Average Value | Range of Thickness | | | | Moisture Absorption Treatment of 1 Hour | Moisture Absorption Treatment under Boiling for 2 Hours | |
| Unit | mm | mm | - | - | kN/m | - | - | - |
| Example 1 | 0.145 | 0.01 | A | A | 1.55 | A | A | 1.8 |
| Example 2 | 0.142 | 0.018 | A | A | 1.54 | A | A | 1.8 |
| Example 3 | 0.147 | 0.01 | B | A | 1.51 | A | A | 1.8 |
| Example 4 | 0.146 | 0.015 | A | B | 1.52 | A | A | 1.6 |
| Example 5 | 0.147 | 0.01 | B | A | 1.51 | A | A | 1.6 |
| Example 6 | 0.146 | 0.021 | A | B | 1.52 | A | A | 1.5 |
| Example 7 | 0.147 | 0.01 | B | A | 1.48 | A | A | 1.4 |
| Example 8 | 0.142 | 0.019 | A | A | 1.49 | A | A | 1.8 |
| Example 9 | 0.076 | 0.012 | A | B | 1.02 | A | A | 1.6 |
| Comp.Ex.1 | 0.146 | 0.041 | A | C | 1.45 | A | A | 1 |

EP 1 260 359 B1

**Effect of the Invention**

According to the present invention, it is possible to provide a method for manufacturing a high quality laminated board with high productivity.

Moreover, when the reactivity of the thermosetting resins constituting the first and second layers of the prepreg are kept at specified values, it is possible to obtain laminated boards superior especially in the sheet thickness precision and the moldability.

Moreover, when the feeding direction of the prepreg is set in the vertical direction, it is possible to obtain a laminated board having smaller variations in the quality of the front and back sides.

Moreover, when the surface layer of the roll is composed of an elastic material, it is possible to have a uniform and firmer adhesion between the prepreg and the metal foil.

Moreover, when using a metal foil having a sticky resin layer, it is possible to prevent occurrence of resin banks, and to manufacture the laminated boards in a stable manner.

Furthermore, when using a metal foil having a sticky resin layer, it is possible to manufacture a laminated board continuously in a stable manner even if a prepreg having a single thermosetting resin layer is employed.

Finally, it is to be noted that, although the present invention was described above with reference to the embodiments and examples, the present invention is not limited thereto, and various modification and additions may be made without departing from the invention which is defined by the following claims.

**Claims**

1. A method for manufacturing a laminated board, comprising the steps of:

    preparing a prepreg (2) having multiple layers, the multiple layers of the prepreg (2) include a first layer (21) having a sheet-form base to which a thermosetting resin is impregnated, the first layer (21) having both surfaces, and a second layer (22a) which is formed onto at least one of the surfaces of the first layer (21) by applying a thermosetting resin thereto; and
    continuously bonding at least one metal foil (4) onto the surface of the second layer (22a) of the prepreg (2),

    **CHARACTERIZED IN THAT** the reactivity of the thermosetting resin used in the first layer (21) is equal to or greater than 85% and the reactivity of the thermosetting resin used in the second layer (22a) is equal to or smaller than 65%.

2. The method for manufacturing a laminated board as claimed in claim 1, wherein the reactivity of the first layer (21) is in the range of 90 to 95% and the reactivity of the second layer (22a) is in the range of 0.1 to 20%.

3. The method as claimed in claim 1, wherein the second layer (22a) is formed onto the both surfaces of the first layer (21), respectively, by applying a thermosetting resin thereto, and the metal foil (4) is continuously bonded onto each of the surfaces of the second layers (22a, 22a).

4. The method as claimed in claim 1, wherein the thermosetting resin for the first layer (21) and the thermosetting resin for the second layer (22a) are the same as to each other.

5. The method as claimed in claim 1, wherein the metal foil (4) is continuously bonded to the prepreg (2) while the prepreg (2) is being fed substantially vertically.

6. The method as claimed in claim 1, wherein the bonding of the metal foil (4) to the prepreg (2) is carried out by passing them through at least one pair of rolls (5).

7. The method as claimed in claim 6, wherein each of the rolls (5) has a surface formed from an elastic material.

8. The method as claimed in claim 1, wherein the metal foil (4) has a sticky resin layer, and the metal foil (4) is continuously bonded to the second layer (22a) of the prepreg (2) through the sticky resin layer.

9. The method as claimed in claim 8, wherein the sticky resin layer contains a thermoplastic resin having a weight average molecular weight of 10,000 or more.

10. The method as claimed in claim 8, wherein the metal foil (4) is a copper foil and the sticky resin layer is formed of varnish provided on one surface of the copper foil (4).

11. The method as claimed in claim 8, wherein the sticky resin layer contains two or more kinds of epoxy resins.

12. The method as claimed in claim 11, wherein the epoxy resins have different molecular weights.

13. The method as claimed in claim 8, wherein the sticky resin layer is comprised of a bisphenolic epoxy resin having a weight average molecular weight of 10,000 or more, a bisphenolic epoxy resin having an epoxy equivalent of 500 or less, and a curing agent.

14. The method as claimed in claim 13, wherein the bisphenolic epoxy resin having a weight average molecular weight of 10,000 or more and the bisphenolic epoxy resin having an epoxy equivalent of 500 or less are compounded in the ratio of (50 to 70) to (50 to 30)wt%.

15. The method as claimed in claim 1, further comprising the step of heating the prepreg (2) prior to the step of the bonding of the metal foil (4) to the second layer (22a) of the prepreg (2).

16. The method as claimed in claim 1, further comprising the step of continuously rolling the laminated board after the step of the bonding of the metal foil (4) to the prepreg (2).


**Patentansprüche**

1. Verfahren zur Herstellung einer mehrschichtigen Platte, aufweisend die Schritte:

   Zubereiten eines Prepreg (2) mit mehreren Schichten, wobei die mehreren Schichten des Prepreg (2) eine erste Schicht (21) umfassen, welche eine Flachmeterialbasis aufweist, die mit einem wärmeaushärtenden Harz getränkt ist, wobei die erste Schicht (21) zwei Oberflächen aufweist, und eine zweite Schicht (22a), die auf zumindest einer der Oberflächen der ersten Schicht (21) durch Auftragen eines wärmeaushärtenden Harzes auf dieser gebildet wird; und
   kontinuierliches Bondieren von zumindest einer Metallfolie (4) auf die Oberfläche der zweiten Schicht (22a) des Prepreg (2), **dadurch gekennzeichnet, dass** die Reaktivität des in der ersten Schicht (21) verwendeten wärmeaushärtenden Harzes gleich oder größer 85% ist, und dass die Reaktivität des wärmeaushärtenden Harzes, welches in der zweiten Schicht (22a) verwendet wird, gleich oder kleiner als 65% ist.

2. Verfahren zum Herstellen einer mehrschichtigen Platte nach Anspruch 1, wobei die Reaktivität der ersten Schicht (21) im Bereich von 90 bis 95% liegt, und wobei die Reaktivität der zweiten Schicht (22a) im Bereich von 0,1 bis 20% liegt.

3. Verfahren nach Anspruch 1, wobei die zweite Schicht (22a) auf den beiden Oberflächen der ersten Schicht (21) durch Auftragen eines wärmeaushärtenden Harzes auf diese gebildet wird, und wobei die Metallfolie (4) auf jede der Oberflächen der zweiten Schicht (22a) kontinuierlich gebondet wird.

4. Verfahren nach Anspruch 1, wobei das wärmeaushärtende Harz für die erste Schicht (21) und das wäremeaushärtende Harz für die zweite Schicht (22a) identisch sind.

5. Verfahren nach Anspruch 1, wobei die Metallfolie (4) auf das Prepreg (2) kontinuierlich gebondet wird, während das Prepreg (2) im Wesentlichen vertikal zugeführt wird.

6. Verfahren nach Anspruch 1, wobei das Bondieren der Metallfolie (4) auf das Prepreg (2) ausgeführt wird, in dem sie durch zumindest ein Paar von Walzen (5) hindurchgeführt werden.

7. Verfahren nach Anspruch 6, wobei jede der Walzen (5) eine aus elastischem Material gebildete Oberfläche aufweist.

8. Verfahren nach Anspruch 1, wobei die Metallfolie (4) eine klebrige Harzschicht aufweist, und wobei die Metallfolie (4) auf die zweite Schicht (22a) des Prepreg (2) durch die klebrige Harzschicht kontinuierlich bondiert wird.

**9.** Verfahren nach Anspruch 8, wobei die klebrige Harzschicht ein thermoplastisches Harz mit einem mittleren Molekulargewicht von 10.000 oder mehr aufweist.

**10.** Verfahren nach Anspruch 8, wobei die Metallfolie (4) eine Kupferfolie ist, und wobei die klebrige Harzschicht aus auf einer Oberfläche der Kupferfolie (4) vorgesehenem Lack gebildet ist.

**11.** Verfahren nach Anspruch 8, wobei die klebrige Harzschicht zwei oder mehr Arten von Epoxydharzen enthält.

**12.** Verfahren nach Anspruch 11, wobei die Epoxydharze unterschiedliche Molekulargewichte aufweisen.

**13.** Verfahren nach Anspruch 8, wobei die klebrige Harzschicht aus einem Bisphenolepoxydharz mit einem mittleren Molekulargewicht von 10.000 oder mehr, einem Bisphenolepoxydharz mit einem Ephoxydequivalent von 500 oder weniger und einem Aushärtungsmittel besteht.

**14.** Verfahren nach Anspruch 13, wobei das Bisphenolepoxydharz mit einem mittleren Molekulargewicht von 10.000 oder mehr und das Bisphenolepoxydharz mit einem Ephoxydäquivalent von 500 oder weniger in einem Verhältnis von (50 bis 70) zu (50 bis 30) Gewichtsprozent kompoundiert sind.

**15.** Verfahren nach Anspruch 1, außerdem aufweisend den Schritt, das Prepreg (2) zu erwärmen vor dem Schritt des Bondierens der Metallfolie (4) auf die zweite Schicht (22a) des Prepreg (2).

**16.** Verfahren nach Anspruch 1, außerdem aufweisend den Schritt, die mehrschichtige Platte nach dem Schritt des Bondierens der Metallfolie (4) auf das Prepreg (2) zu walzen.

**Revendications**

**1.** Procédé de fabrication d'une plaque stratifiée, comprenant les étapes consistant à :

préparer un préimprégné (2) comprenant des couches multiples, les couches multiples du préimprégné (2) comprennent une première couche (21) ayant une base en forme de feuille sur laquelle une résine thermodurcissable est imprégnée, la première couche (21) ayant deux surfaces, et une deuxième couche (22a) qui est formée sur au moins une des surfaces de la première couche (21) en appliquant une résine thermodurcissable sur celle-ci ; et
souder de manière continue au moins une feuille de métal (4) sur la surface de la deuxième couche (22a) du préimprégné (2),

**caractérisé en ce que** la réactivité de la résine thermodurcissable utilisée dans la première couche (21) est égale ou supérieure à 85 % et la réactivité de la résine thermodurcissable utilisée dans la deuxième couche (22a) est égale ou inférieure à 65 %.

**2.** Procédé de fabrication d'une plaque stratifiée selon la revendication 1, dans lequel la réactivité de la première couche (21) est comprise dans la plage de 90 à 95 % et la réactivité de la deuxième couche (22a) est comprise dans la plage de 0,1 à 20 %.

**3.** Procédé selon la revendication 1, dans lequel la deuxième couche (22a) est formée sur les deux surfaces de la première couche (21), respectivement, en appliquant une résine thermodurcissable sur celle-ci, et la feuille de métal (4) est soudée de manière continue sur chacune des surfaces des deuxièmes couches (22a, 22a).

**4.** Procédé selon la revendication 1, dans lequel la résine thermodurcissable pour la première couche (21) et la résine thermodurcissable pour la deuxième couche (22a) sont identiques l'une à l'autre.

**5.** Procédé selon la revendication 1, dans lequel la feuille de métal (4) est soudée de manière continue au préimprégné (2) alors que le préimprégné (2) est amené sensiblement verticalement.

**6.** Procédé selon la revendication 1, dans lequel le soudage de la feuille de métal (4) sur le préimprégné (2) est réalisé en les passant à travers au moins une paire de rouleaux (5).

**7.** Procédé selon la revendication 6, dans lequel chacun des rouleaux (5) comprend une surface formée à partir d'un matériau élastique.

**8.** Procédé selon la revendication 1, dans lequel la feuille de métal (4) présente une couche de résine collante, et la feuille de métal (4) est soudée de manière continue à la deuxième couche (22a) du préimprégné (2) à travers la couche de résine collante.

**9.** Procédé selon la revendication 8, dans lequel la couche de résine collante contient une résine thermoplastique présentant une masse moléculaire moyenne pondérée de 10 000 ou plus.

**10.** Procédé selon la revendication 8, dans lequel la feuille de métal (4) est une feuille de cuivre et la couche de résine collante est formée de vernis prévu sur une surface de la feuille de cuivre (4).

**11.** Procédé selon la revendication 8, dans lequel la couche de résine collante contient deux types de résines époxy ou plus.

**12.** Procédé selon la revendication 11, dans lequel les résines époxy présentent différentes masses moléculaires.

**13.** Procédé selon la revendication 8, dans lequel la couche de résine collante est composée d'une résine époxy au bisphénol présentant une masse moléculaire moyenne pondérée de 10 000 ou plus, une résine époxy au bisphénol comprenant un équivalent d'époxy de 500 ou moins, et un agent durcissant.

**14.** Procédé selon la revendication 13, dans lequel la résine époxy au bisphénol présentant une masse moléculaire moyenne pondérée de 10 000 ou plus et la résine époxy au bisphénol présentant un équivalent d'époxy de 500 ou moins sont composées dans le rapport de (50 à 70) sur (50 à 30) % en masse.

**15.** Procédé selon la revendication 1, comprenant en outre l'étape consistant à chauffer le préimprégné (2) avant l'étape consistant à souder la feuille de métal (4) sur la deuxième couche (22a) du préimprégné (2).

**16.** Procédé selon la revendication 1, comprenant en outre l'étape consistant à rouler de manière continue la plaque stratifiée après l'étape consistant à souder la feuille de métal (4) sur le préimprégné (2).

F i g. 1

Fig. 2

Fig. 3